# EUROPEAN PATENT SPECIFICATION

(11) **EP 1 622 238 B1**
(45) Date of publication and mention of the grant of the patent: **09.03.2011**
(21) Application number: 05014632.3
(22) Date of filing: 06.07.2005
(51) Int. Cl.: H01S 5/183, H01S 5/026, H01S 5/042, H01S 5/068, H01L 27/15, H01L 33/00

(54) **Surface-emitting light source and method for manufacturing the same**
Oberflächenemittierende Lichtquelle und deren Herstellungsverfahren
Source de lumière à émission par la surface et son procédé de fabrication

(30) Priority: 29.07.2004 JP 2004221761; 21.09.2004 JP 2004273352
(43) Date of publication of application: 01.02.2006
(73) Proprietor: Seiko Epson Corporation, Shinjuku-ku, Tokyo 163-0811 (JP)
(72) Inventor: Nishida, Tetsuo, Suwa-shi Nagano-ken 392-8502 (JP); Onishi, Hajime, Suwa-shi Nagano-ken 392-8502 (JP)
(74) Representative: MERH-IP Matias Erny Reichl Hoffmann

(56) References cited:
- EP-A- 0 406 506
- EP-A- 0 933 842
- EP-A- 0 935 322
- WO-A-2005/055379
- DE-A1- 19 945 134
- US-A1- 2003 228 716
- PATENT ABSTRACTS OF JAPAN vol. 1997, no. 05, 30 May 1997 (1997-05-30) & JP 09 027657 A (OKI ELECTRIC IND CO LTD), 28 January 1997 (1997-01-28)
- PATENT ABSTRACTS OF JAPAN vol. 011, no. 231 (E-527), 28 July 1987 (1987-07-28) -& JP 62 045193 A (HITACHI LTD), 27 February 1987 (1987-02-27)
- PATENT ABSTRACTS OF JAPAN vol. 1995, no. 03, 28 April 1995 (1995-04-28) & JP 06 334271 A (SONY CORP), 2 December 1994 (1994-12-02)

## Description

The present invention relates to surface-emitting type devices and methods for manufacturing the same.

A surface-emitting type semiconductor laser has a smaller element volume compared to a conventional edge emitting semiconductor laser, and therefore the electrostatic breakdown strength of the element itself is low. For this reason, in a mounting process, the element may be damaged by static electricity caused by machines and/or operators. In particular, a surface emitting type device such as a surface-emitting type semiconductor laser has some withstanding strength against voltages in forward bias, but is low in withstanding strength against voltages in reverse bias, such that the element may be destroyed upon application of a voltage in reverse bias. Normally, a variety of measures are implemented to remove static electricity in the mounting process, but these measures have limitations.
[Patent Document 1] Japanese Laid-open Patent Application 2004-6548

DE 199 45 134 A1 discloses a surface-emitting type device, in which a first mirror is arranged on a substrate. An active layer including a pn junction is provided on the first mirror. Upon the active layer a second mirror is provided. This arrangement is the same both in a light emitting element section as well as a rectification element section. The pn junction for light emission in the light emitting element section is used for a diode function in the rectification element section. A protective effect is achieved in this prior art by the series circuit of the pn junction and a Schottky contact.

US 2003/0228716 A1 discloses a monolithically integrated VCSEL and photodetector, and a method of manufacturing the same. One embodiment builds layers of a p-i-n photodiode on top of layers forming a VCSEL using a standard VCSEL process. The p-i-n layers are etched away in areas where VCSELs are to be formed and left where photodetectors are to be formed. An undoped GaAs layer is described as forming the intrinsic layer of the p-i-n photodiode. The thicker this GaAs layer the lower the capacitance of the p-i-n photodiode.

WO-A-2005 055 379 discloses a VCSEL with a monolithically integrated protection diode.

It is an object of the present invention to prevent electrostatic breakdown and improve reliability in surface-emitting type devices and methods for manufacturing the same.
(1) A surface-emitting type device in accordance with the present invention, includes:
   a substrate;
   a light emitting element section above the substrate, including a first semiconductor section of a first conductivity type, a second semiconductor section that functions as an active layer, and a third semiconductor section of a second conductivity type which are disposed from a side of the substrate; a rectification element section above the substrate, including a first supporting section composed of the same composition as that of the first semiconductor section, a second supporting section composed of the same composition as that of the second semiconductor section, a fourth semiconductor section and a fifth semiconductor section, which are disposed from the side of the substrate; and
   first and second electrodes for driving the light emitting element section,
   wherein the fourth and fifth semiconductor sections are connected in parallel between the first and second electrodes, and have a rectification action in a reverse direction with respect to the light emitting element section.

   According to the present invention, even when a voltage in reverse bias is impressed to the light emitting element section, a current flows to the semiconductor section of the rectification element section that is connected in parallel with the light emitting element section. By this, the electrostatic breakdown strength against voltages in reverse bias can be considerably improved. Accordingly, electrostatic breakdown in a mounting process can be prevented, and the reliability can be improved.
   It is noted that, in the present invention, the case where a layer B is provided above a specific layer A includes a case where the layer B is directly provided on the layer A, and a case where the layer B is provided over the layer A through another layer. This similarly applies to the following inventions.
(2) In the surface-emitting type device,
   the fourth semiconductor section may be formed in the second conductivity type, and
   the fifth semiconductor section may be formed in the first conductivity type.
   By this, a junction diode may be formed by the fourth and fifth semiconductor sections.
(3) In the surface-emitting type device, the fourth semiconductor section may be formed in the same composition as that of the third semiconductor section.
(4) In the surface-emitting type device, a capacitance reducing section may be provided between the fourth and fifth semiconductor sections.
   By this, the capacitance of the junction diode can be reduced, such that high-speed driving of the surface-emitting type device can be achieved.
(5) In the surface-emitting type device, the capacitance reducing section may be composed of an intrinsic semiconductor.
   By this, a pin diode may be composed by the fourth semiconductor section, the capacitance reducing section and the fifth semiconductor section.
(6) In the surface-emitting type device, the capacitance reducing section may be composed of a semiconductor having an impurity concentration lower than that of the fourth and fifth semiconductor sections.
(7) In the surface-emitting type device, the fourth semiconductor section may include a GaAs layer at an uppermost surface thereof, and the capacitance reducing section may include an AlGaAs layer.
(8) In the surface-emitting type device,
   the third semiconductor section may include at least two layers of different compositions,
   the fourth semiconductor section may include the same composition as that of at least one of the two layers of different compositions, and
   the fifth semiconductor section may include the same composition as that of at least the other of the two layers of different compositions.
(9) In the surface-emitting type device,
   the light emitting element section may function as a surface-emitting type semiconductor laser,
   the first semiconductor section may function as a first mirror, and
   the third semiconductor section may function as a second mirror.
(10) A method for manufacturing a surface-emitting type device in accordance with the present invention includes the steps of:
   (a) forming, above a substrate, a first semiconductor layer of a first conductivity type, a second semiconductor layer that functions as an active layer, a third semiconductor layer of a second conductivity type, and a fourth semiconductor layer of the first conductivity type;
   (b) patterning at least the third and fourth semiconductor layers to form a light emitting element section including a first semiconductor section of the first conductivity type, a second semiconductor section that functions as the active layer, and a third semiconductor section of the second conductivity type, which are disposed above the substrate from a side of the substrate, and a rectification element section including a first supporting section composed of an identical composition of the first semiconductor section, a second supporting section composed of an identical composition of the second semiconductor section, a fourth semiconductor section of the second conductivity type and a fifth semiconductor section of the first conductivity type, which are disposed above the substrate from the side of the substrate;
   (c) forming first and second electrodes for driving the light emitting element section; and
   (d) connecting the fourth and fifth semiconductor sections in parallel between the first and second electrodes to have a rectification action in a reverse direction with respect to the light emitting element section.

   According to the present invention, a junction diode is formed by the fourth and fifth semiconductor sections, and the junction diode is connected in parallel in a direction that provides a rectification action in a reverse direction with respect to the light emitting element section. By this, even when a voltage in reverse bias is impressed to the light emitting element section, a current flows to the junction diode, such that the electrostatic breakdown strength against voltages in reverse bias can be considerably improved. Accordingly, electrostatic breakdown in a mounting process or the like can be prevented, and the reliability can be improved.
(11) In the method for manufacturing a surface-emitting type device,
   the step (a) may further include forming a capacitance reducing layer between the third and fourth semiconductor layers, and
   the step (b) may further include patterning the capacitance reducing layer between the fourth and fifth semiconductor sections.
   By this, the capacitance of the junction diode can be reduced, such that high-speed driving of the surface-emitting type device can be realized.
(12) In the method for manufacturing a surface-emitting type device, the third semiconductor layer may include a GaAs layer at a topmost layer thereof, and the capacitance reducing layer may include an AlGaAs layer, wherein the capacitance reducing layer may be patterned by wet-etching in the step (b).

By this, an etching selection ratio is obtained between the capacitance reducing layer and the third semiconductor layer, such that selective etching of the capacitance reducing layer can be readily conducted.

Embodiments of the present invention are described below with reference to the accompanying drawings.
- FIG. 1: is a plan view of a surface-emitting type device in accordance with a first embodiment of the present invention.
- FIG. 2: is a cross-sectional view taken along a line II-II of FIG. 1.
- FIG. 3: is a circuit diagram of the surface-emitting type device in accordance with the first embodiment of the present invention.
- FIG.4: is a view showing a method for manufacturing the surface-emitting type device in accordance with the first embodiment of the present invention.
- FIG. 5: is a view showing the method for manufacturing the surface-emitting type device in accordance with the first embodiment of the present invention.
- FIG. 6: is a view showing the method for manufacturing the surface-emitting type device in accordance with the first embodiment of the present invention.
- FIG. 7: is a view showing the method for manufacturing the surface-emitting type device in accordance with the first embodiment of the present invention.
- FIG. 8: is a view showing the method for manufacturing the surface-emitting type device in accordance with the first embodiment of the present invention.
- FIG. 9: is a cross-sectional view of a surface-emitting type device in accordance with an example relating to background of the present invention.
- FIG. 10: is a view showing a method for manufacturing the surface-emitting type device in accordance with the example relating to background of the present invention.
- FIG. 11: is a view showing the method for manufacturing the surface-emitting type device in accordance with the example relating to background of the present invention.
- FIG. 12: is a view showing the method for manufacturing the surface-emitting type device in accordance with the example relating to background of the present invention.
- FIG. 13: is a view showing the method for manufacturing the surface-emitting type device in accordance with the example relating to background of the present invention.
- FIG. 14: is a view showing the method for manufacturing the surface-emitting type device in accordance with the example relating to background of the present invention.
- FIG. 15: is a diagram showing optical transmission devices in accordance with a second embodiment of the present invention.
- FIG. 16: is a diagram showing a usage configuration of optical transmission devices in accordance with a third embodiment of the present invention.
- FIG. 17: is a plan view of a surface-emitting type device in accordance with a fourth embodiment of the present invention.
- FIG. 18: is a cross-sectional view taken along a line XVII-XVII of FIG. 17.
- FIG. 19: is a view showing a method for manufacturing the surface-emitting type device in accordance with the fourth embodiment of the present invention.
- FIG. 20: is a view showing the method for manufacturing the surface-emitting type device in accordance with the fourth embodiment of the present invention.
- FIG. 21: is a view showing the method for manufacturing the surface-emitting type device in accordance with the fourth embodiment of the present invention.
- FIG. 22: is a view showing the method for manufacturing the surface-emitting type device in accordance with the fourth embodiment of the present invention.

### First Embodiment

### 1 - 1. Surface-Emitting Type Device

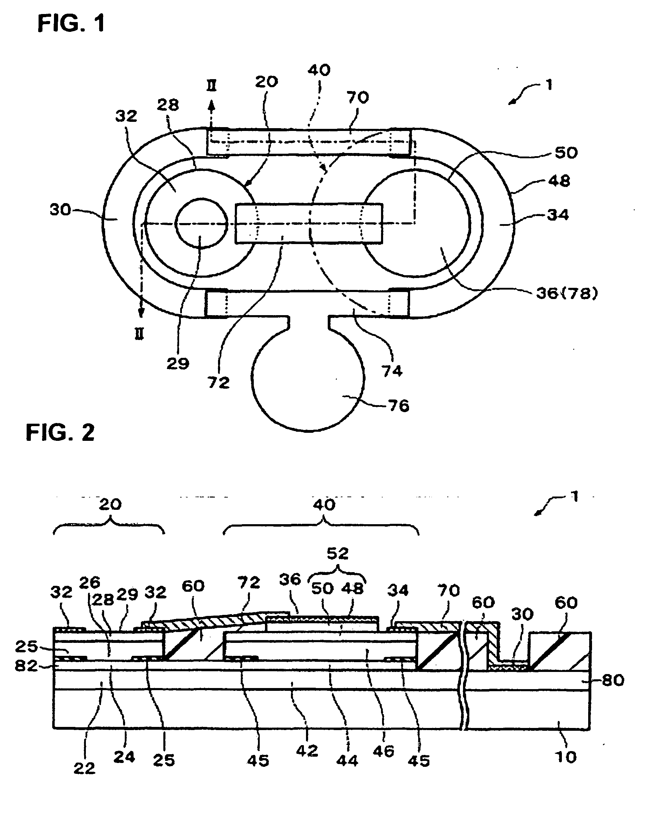

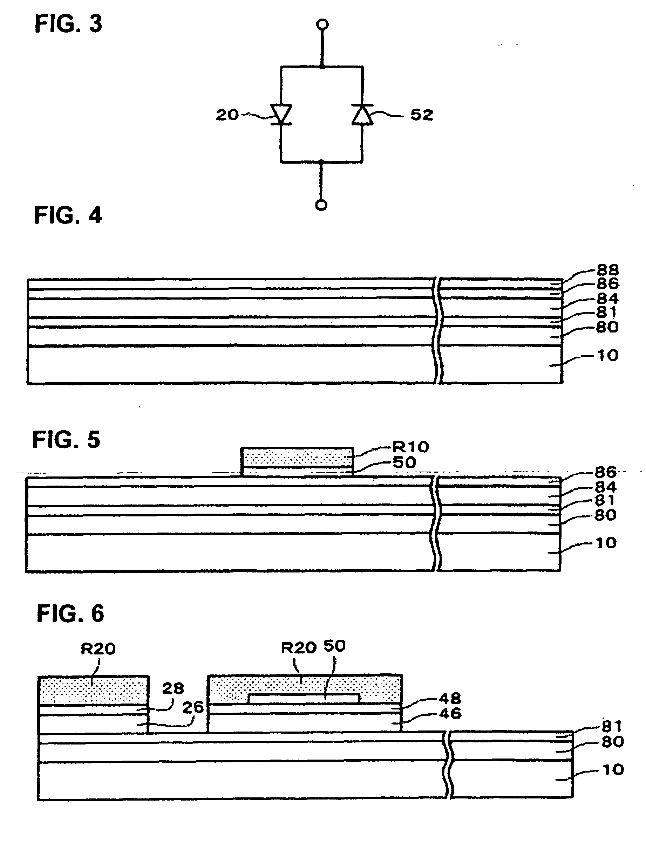

FIG. 1 is a plan view of a surface-emitting type device in accordance with a first embodiment of the present invention. FIG. 2 is a cross-sectional view taken along a line II-II of FIG. 1. FIG. 3 is a circuit diagram of the surface-emitting type device in accordance with the present embodiment.

The surface-emitting type device 1 includes a substrate 10, a light emitting element section 20, and a rectification element section 40. In the present embodiment, a case in which the surface-emitting type device is a surface-emitting type semiconductor laser is described as an example.

The substrate 10 is a semiconductor substrate (for example, n-type GaAs substrate). The substrate 10 supports the light emitting element section 20 and the rectification element section 40. In other words, the light emitting element section 20 and the rectification element section 40 are formed on the same substrate (the same chip), and has a monolithic structure.

The light emitting element section 20 is formed on the substrate 10. A single light emitting element section 20 may be formed on a single substrate 10, or a plurality of light emitting element sections 20 may be formed thereon. An upper surface of the light emitting element section 20 defines a light emission surface 29. The light emitting element section 20 has a plane configuration that is a circular shape, but is not limited to this shape. In the case of a surface-emitting type semiconductor laser, the light emitting element section 20 is called a vertical resonator.

The light emitting element section 20 includes a first semiconductor section 22 of a first conductivity type (for example, n-type), a second semiconductor section 24 that functions as an active layer, and third semiconductor sections 26 and 28 of a second conductivity type (for example, p-type), which are disposed from the side of the substrate 10.

The first semiconductor section 22 may be, for example, a distributed reflection type multilayer mirror of 40 pairs of alternately laminated n-type Al_{0.9}Ga_{0.1}As layers and n-type Al_{0.5}Ga_{0.855}As layers (first mirror). The second semiconductor section 24 may be composed of, for example, GaAs well layers and Al_{0.3}Ga_{0.7}As barrier layers in which the well layers include a quantum well structure composed of three layers. The third semiconductor section 26 may be, for example, a distributed reflection type multilayer mirror of 25 pairs of alternately laminated p-type Al_{0.9}Ga_{0.1}As layers and p-type Al_{0.15}Ga_{0.85}As layers (second mirror). Also, the third semiconductor section 28 at the topmost surface may be a contact section composed of, for example, p-type GaAs layers. It is noted that the composition of each of the layers and the number of the layers forming the first semiconductor section 22, the second semiconductor section 24, and the third semiconductor sections 26 and 28 are not limited to the above.

The third semiconductor sections 26 and 28 are made to be p-type by doping C, Zn, Mg or the like, and the first semiconductor section 22 is made to be n-type by doping Si, Se or the like. Accordingly, the third semiconductor sections 26 and 28, the second semiconductor section 24 in which no impurity is doped, and the first semiconductor section 22 form a pin diode.

A dielectric layer 25 is formed in a region near the second semiconductor section 24 that functions as an active layer among the layers composing the third semiconductor section 26. The dielectric layer 25 functions as a current constricting layer. The dielectric layer 25 may be formed, for example, in a ring shape along the circumference of the plane configuration of the light emitting element section 20. The dielectric layer 25 can be formed from aluminum oxide as a main component.

At the light emitting element section 20, first and second electrodes 30 and 32 for driving are formed.

The first electrode 30 is electrically connected to the first semiconductor section 22, and may be formed, for example, on a portion that is continuous with the first semiconductor section 22 (on a first semiconductor layer 80 shown in FIG. 2). As shown in FIG. 1, the first electrode 30 is formed outside the third semiconductor section 28, and extends in a manner, for example, to encircle a half of the outer circumference of the third semiconductor section 28. The first electrode 30 can be formed from a multilayer film of, for example, Au and an alloy of Au and Ge.

The second electrode 32 is electrically connected to the third semiconductor sections 26 and 28, and may be formed, for example, on the third semiconductor section 28 that is a contact section. As shown in FIG. 1, the second electrode 32 may be formed in a ring shape along an edge section of the upper surface of the third semiconductor section 28. In this case, a center section of the upper surface of the third semiconductor section 28 defines an emission surface 29. The second electrode 32 can be formed from a multilayer film of, for example, Au and an alloy of Au and Zn.

A current can be circulated to the second semiconductor section 24 that functions as an active layer by the first and second electrodes 30 and 32. It is noted that the materials of the first and second electrodes 30 and 32 are not limited to the above, and metals, such as, for example, Ti, Ni, Au or Pt, or an alloy of these metals can be used.

The rectification element section 40 is formed on a region on the substrate 10 which is different from the light emitting element section 20. The rectification element section 40 has a rectification action. The rectification element section 40 of the present embodiment includes a junction diode 52 (including a zener diode).

The rectification element section 40 includes a first supporting section 42 composed of the same composition as that of the first semiconductor section 22, a second supporting section 44 composed of the same composition as that of the second semiconductor section 24, fourth semiconductor sections 46 and 48, and a fifth semiconductor section 50, which are disposed from the side of the substrate 10.

The first supporting section 42 may be formed continuously with the first semiconductor section 22. In other words, the first semiconductor layer 80 is formed on the substrate 10, a part of the first semiconductor layer 80 may define the first semiconductor section 22, and another part thereof may define the first supporting section 42. Also, the second supporting section 44 may be formed continuously with the second semiconductor section 24. In other words, a second semiconductor layer 82 is formed on the first semiconductor layer 80, a part of the second semiconductor layer 82 may define the second semiconductor section 24, and another part thereof may define the second supporting section 44. Alternatively, the second supporting section 44 may be separated from the second semiconductor section 24.

The fourth semiconductor sections 46 and 48 are composed of a second conductivity type (for example, p-type), and the fifth semiconductor section 50 is composed of a first conductivity type (for example, n-type). By this, a pn junction diode can be formed at an interface between the fourth and fifth semiconductor sections 48 and 50. It is noted that not only the fourth semiconductor section 48 but also the fourth semiconductor section 46 may contribute to operations of the pn junction diode.

The fourth semiconductor sections 46 and 48 may be formed in the same composition as that of the third semiconductor sections 26 and 28. In the example shown in FIG. 2, the fourth semiconductor section 46 is formed in the same composition as that of the third semiconductor section 26 that is a mirror, and the fourth semiconductor section 48 is formed in the same composition as that of the third semiconductor section 28 that is a contact section. It is noted that a dielectric layer 45 may be formed in a region near the second supporting section 44 among the layers composing the fourth semiconductor section 46. The dielectric layer 45 may be formed in the same process for forming the dielectric layer 25 that functions as the current constriction layer.

The fifth semiconductor section 50 may be formed from, for example, an n-type GaAs layer. In the present embodiment, the fifth semiconductor section 50 is not limited to any material as long as it has a conductivity type different from that of the fourth semiconductor sections 48 and 48. For example, the fifth semiconductor section 50 may have a conductivity type different from that of the fourth semiconductor sections 46 and 48, and may be formed with the same composition as that of at least a part of the fourth semiconductor sections 46 and 48 (for example, the fourth semiconductor section 48).

Third and fourth electrodes 34 and 36 for driving are formed at the rectification element section 40.

The third electrode 34 is electrically connected to the fourth semiconductor sections 46 and 48. For example, the fifth semiconductor section 50 may be formed on a part of the fourth semiconductor section 48, and the third electrode 34 may be formed in an exposed region of the fourth semiconductor section 48. As shown in FIG. 1, the third electrode 34 is formed outside the fifth semiconductor section 50, and extends in a manner, for example, to encircle a half of the outer circumference of the fifth semiconductor section 50 (along the circumference of the fourth semiconductor section 48). The third electrode 34 may be formed in the same composition as that of the second electrode 32 that corresponds to the same conductivity type (the second conductivity type (for example, p-type)).

On the other hand, the fourth electrode 36 is electrically connected to the fifth semiconductor section 50, and may be formed, for example, on an upper surface of the fifth semiconductor section 50. Because light is not emitted from the upper surface of the fifth semiconductor section 50, the entire upper surface of the fifth semiconductor section 50 may be covered by the fourth electrode 36. The fourth electrode 36 may be formed in the same composition as that of the first electrode 30 that corresponds to the same conductivity type (the first conductivity type (for example, n-type)).

The fourth and fifth semiconductor sections 48 and 50 (junction diode 52) are connected in parallel between the first and second electrodes 30 and 32, and have a rectification action in a reverse direction with respect to the light emitting element section 20. More specifically, the third electrode 34 on the fourth semiconductor section 48 and the first electrode 30 are electrically connected by a wiring 70, and the fourth electrode 36 on the fifth semiconductor section 50 and the second electrode 32 are electrically connected by a wiring 72.

In accordance with the present embodiment, even when a voltage in reverse bias is impressed to the light emitting element section 20, a current flows to the fourth and fifth semiconductor sections 48 and 50 (junction diode 52) of the rectification element section 40 that is connected in parallel with the light emitting element section 20. By this, the surface-emitting type device 1 can be considerably improved in its electrostatic breakdown strength against voltages in reverse bias. Accordingly, because electrostatic breakdown in a mounting process can be prevented, it excels in handling and its reliability can be improved.

On the other hand, when the light emitting element section 20 is driven, a voltage in forward bias is impressed to the light emitting element section 20. In this case, because a current is flown only to the light emitting element section 20, the breakdown voltage of the junction diode 52 is preferably greater than the drive voltage of the light emitting element section 20. By so doing, even when a voltage in forward bias is impressed at the time of driving the light emitting element section 20, no (or almost no) reverse current flows in the fourth and fifth semiconductor sections 48 and 50 (junction diode 52), such that the light emitting element section 20 normally performs a light emission operation.

It is noted here that the breakdown voltage value of the junction diode 52 can be suitably controlled by adjusting compositions and/or impurity concentrations of the fourth and fifth semiconductor sections 48 and 50. For example, the breakdown voltage of the junction diode 52 can be increased by reducing the impurity concentration of the fourth and fifth semiconductor sections 48 and 50. In the case of the present embodiment, the fourth and fifth semiconductor sections 48 and 50 are formed independently of the semiconductor sections that contribute to the light emission operation of the light emitting element section 20, respectively. In particular, because the fifth semiconductor section 50 can be formed without depending on the structure of the light emitting element section 20, its composition and impurity concentration can be freely adjusted. Accordingly, the junction diode 52 having more ideal characteristics can be readily formed, its electrostatic breakdown can be effectively prevented, and more stable light emission operations thereof can be realized.

Alternatively, by adjusting compositions and/or impurity concentrations of the first and third semiconductor sections 22, and 26 and 28 of the light emitting element section 20, respectively, the drive voltage value of the light emitting element section 20 may be made smaller than the breakdown voltage value of the junction diode 52.

As shown in FIG. 1, the first electrode 30 is formed in a U-shape in a manner to encircle the outer circumference of the second electrode 32, and the third electrode 34 is formed in a U-shape in a manner to encircle the outer circumference of the fourth electrode 36. Then, the first and the third electrodes 30 and 34 are symmetrically disposed with their end sections opposing to each other, one end sections thereof are electrically connected to each other by a wiring 70, and the other end sections thereof are electrically connected to each other by wiring 74. A first electrical connection section 76 may be provided at one of the wirings (the wiring 74 in FIG. 1). Also, the second and fourth electrodes 32 and 36 are electrically connected by a wiring 72 in a region surrounded by the first and third electrodes 30 and 34, and the wirings 70 and 74. The third electrode 34 may concurrently serve as the second electrical connection section 78. It is noted that the wirings 70, 72 and 74 and the first electrical connection section 76 are formed on a resin layer (for example, a polyimide resin layer) 60 (see FIG. 2).

In the surface-emitting type device 1 in accordance with the present embodiment, a voltage is impressed through the first and second electrical connection sections 76 and 78. In the light emitting element section 20, when applying a voltage in a forward direction to the pin diode between the first and second electrodes 30 and 32, the second semiconductor section 24 functions as an active layer, and recombinations of electrons and holes occur, thereby causing emission of light due to the recombinations. Stimulated emission occurs during the period the generated light reciprocates between the first semiconductor section 22 and the third semiconductor section 26, whereby the light intensity is amplified. When the optical gain exceeds the optical loss, laser oscillation occurs, and laser light is emitted from the light emission surface 29 in a direction orthogonal to the substrate 10.

It is noted that the present invention is not limited to surface-emitting type semiconductor lasers, but is also applicable to other surface-emitting type devices (for example, semiconductor light emission diodes, organic LEDs, etc.). Also, the p-type and n-type of each of the semiconductors described above may be interchanged. Moreover, in the examples described above, the description is made as to an AlGaAs type, but depending on the oscillation wavelength to be generated, other materials, such as, for example, GalnP type, ZnSSe type, InGaN type, AlGaN type, InGaAs type, GalnNAs type, GaAsSb type, and like semiconductor materials can be used.

### 1 - 2. Method of Manufacturing Surface-emitting Type Device

FIGS. 4 - 8 are figures showing a method for manufacturing a surface-emitting type device in accordance with the first embodiment of the present invention.

As shown in FIG. 4, on a substrate 10, a first semiconductor layer 80 of a first conductivity type (for example, n-type), a second semiconductor layer 81 that functions as an active layer, third semiconductor layers 84 and 86 of a second conductivity type (for example, p-type), and a fourth semiconductor layer 88 of the first conductivity type (for example, n-type) are formed by epitaxial growth while varying the composition. The compositions of the first through third semiconductor layers 80, 81, 84 and 86 correspond to the details of the first through third semiconductor sections 22, 24, 26 and 28 described above, respectively, and the composition of the fourth semiconductor layer 88 corresponds to the details of the fifth semiconductor section 50 described above.

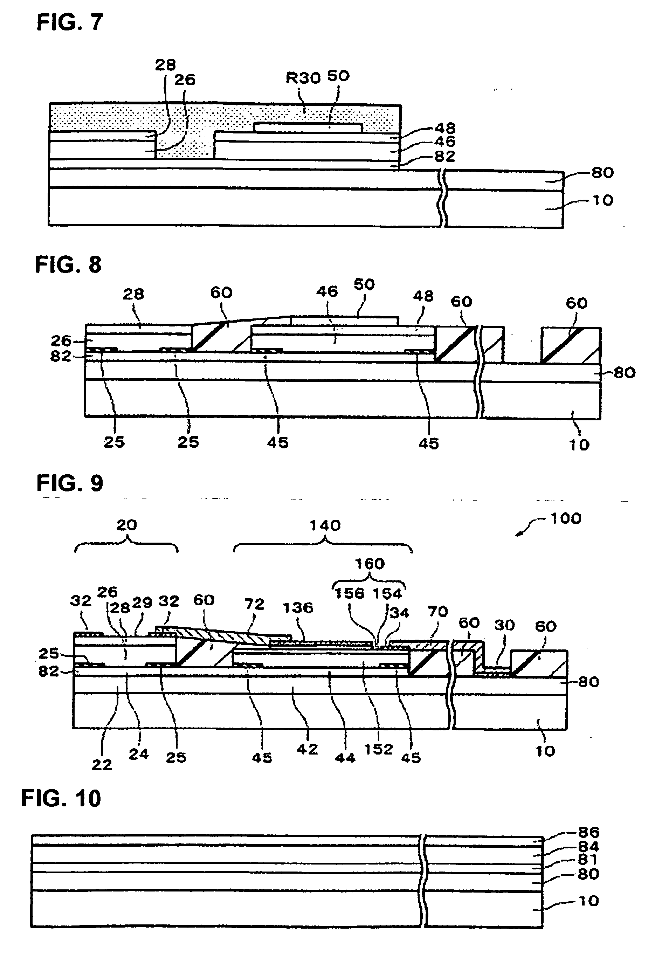

It is noted that, when growing the third semiconductor layer 84, at least one layer adjacent to the second semiconductor layer 81 that functions as an active layer is formed as an AlAs layer or an AlGaAs layer having Al composition being 0.95 or greater. This layer is later oxidized, and becomes a dielectric layer 25 that functions as a current constricting layer (see FIG. 8). Also, by forming the third semiconductor layer 86 at the uppermost surface to have a function as a contact section, ohmic contact between the second electrode 32 and the third electrode 34 can be readily formed.

The temperature at which the epitaxial growth is conducted is appropriately decided depending on the growth method, the kind of raw material, the type of the semiconductor substrate 10, and the kind, thickness and carrier density of each of the semiconductor layers to be formed, and in general may preferably be 450 °C - 800 °C. Also, the time required when the epitaxial growth is conducted is appropriately decided just like the temperature. Also, a metal-organic vapor phase deposition (MOVPE: Metal-Organic Vapor Phase Epitaxy) method, a MBE method (Molecular Beam Epitaxy) method or a LPE (Liquid Phase Epitaxy) method can be used as a method for the epitaxial growth.

Next, as shown in FIG. 5 - FIG. 7, at least the third and the fourth semiconductor layers 84 and 86, and 88 are patterned to form a light emitting element section 20 and a rectification element section 40.

First, as shown in FIG. 5, the fourth semiconductor layer 88 at the uppermost layer may be patterned. More specifically, resist is coated on the fourth semiconductor layer 88, and the resist is patterned, thereby forming a resist layer R10 having a predetermined pattern. Then, by using the resist layer R10 as a mask, etching (for example dry-etching or wet-etching) is conducted to form a fifth semiconductor section 50.

Next, as shown in FIG. 6, the third semiconductor layers 84 and 86 are patterned. More specifically, a resist layer R20 is formed in a similar manner as described above, and etching is conducted by using the resist layer R20 as a mask. By patterning the third semiconductor layer 84, a third semiconductor section 26 that functions as a mirror, and a fourth semiconductor section 46 can be formed, and by patterning the third semiconductor layer 86, a third semiconductor section 28 that functions as a contact section and a fourth semiconductor section 48 can be formed.

As shown in FIG. 7, the second semiconductor layer 81 may also be patterned. More specifically, a resist layer R30 is formed in a similar manner as described above, and etching is conducted by using the resist layer R30 as a mask to thereby form a second semiconductor layer 82, and expose at least a portion of the first semiconductor layer 80. By this, a first electrode 30 can be formed in an exposed region of the first semiconductor layer 80.

It is noted that, without being limited to the order in the above-described patterning method, patterning may be conducted, for example, from the side near the substrate 10, i.e., the second semiconductor layer 81, the third semiconductor layers 84 and 86, and fourth semiconductor layer 88 may be patterned in this order.

Next, as shown in FIG. 8, by placing the semiconductor substrate 10 on which the light emitting element section 20 and the rectification element section 40 are supported in a water vapor atmosphere at about 400°C, for example, the layers having a high rate of Al composition (layers with Al composition being 0.95 or greater) in the third and fourth semiconductor sections 26 and 46 described above are oxidized from their side surfaces, thereby forming dielectric layers 25 and 45. The oxidation rate depends on the temperature of the furnace, the amount of water vapor supply, and the Al composition and the film thickness of the layer to be oxidized. In the surface-emitting type semiconductor laser that has the dielectric layer 25 in the light emitting section 20, an electric current flows, when it is driven, only in a portion where the dielectric layer 25 is not formed (i.e., a portion that has not been oxidized). Therefore, the current density can be controlled by controlling the forming region of the dielectric layer 25, in the process of forming the dielectric layer 25 by oxidation.

Then, a resin layer 60 is formed by patterning in a predetermined region of the substrate 10. The resin layer 60 can be formed by a known technique, such as, a dipping method, a spray coat method, a droplet ejection method (for example, an ink jet method), or the like. The resin layer 60 is formed while avoiding forming areas of first through fourth electrodes 30, 32, 34 and 36 to be described below. The resin layer 60 can be formed from, for example, polyimide resin, fluororesin, acrylic resin, or epoxy resin, and more particularly, it may preferably be formed from polyimide resin or fluororesin in view of their good workability and dielectric property.

Then, the first through fourth electrodes 30, 32, 34 and 36 are formed, and wirings 70, 72 and 74 for electrically connecting specified ones of the electrodes (see FIG. 1 and FIG. 2). The descriptions of the above-described surface-emitting type device can be applied to forming positions of the electrodes and the wirings, and details of their connection relations. Before the electrodes are formed, forming areas of these electrodes may be washed by using plasma processing if necessary. Also, as a method for forming electrodes, for example, at least one layer of conductive layer may be formed by a vacuum deposition method, and then, a part of the conductive layer may be removed by a lift-off method. It is noted that, instead of the lift-off method, a dry-etching method may be used. A method for forming the wirings may be similar to the method for forming the electrodes.

In this manner, a junction diode 52 is formed by the fourth and fifth semiconductor sections 48 and 50, and the junction diode 52 is connected in parallel between the first and second electrodes 30 and 32 in a direction that causes a rectification action in a reverse direction with respect to the light emitting element section 20. By this, even when a voltage in reverse bias is impressed to the light emitting element section 20, a current flows to the junction diode 52, such that the electrostatic breakdown strength against voltages in reverse bias can be considerably improved. Accordingly, electrostatic breakdown in a mounting process or the like can be prevented, and the reliability can be improved.

Also, according to the process described above, after the process of growing the multiple semiconductor layers on the substrate 10 is completed, the semiconductor layers are patterned, such that the manufacturing process can be simplified, compared to a case, for example, where semiconductor layer growing steps and patterning steps are alternately repeated.

It is noted that the method for manufacturing a surface-emitting type device in accordance with the present embodiment includes details that can be derived from the explanation of the surface-emitting type device described above.

### Example relating to background of the present invention

### 2 - 1. Surface-emitting Type Device

FIG. 9 is a cross-sectional view of a surface-emitting type device in accordance with an example relating to background of the present invention. The surface-emitting type device 100 includes a substrate 10, a light emitting element section 20, and a rectification element section 140, and the rectification element section 140 is different in structure from the first embodiment. Details of the substrate 10 and the light emitting element section 20 are the same as described in the first embodiment.

The rectification element section 140 in accordance with the present example includes a Schottky diode 160. More specifically, the rectification element section 140 includes a first supporting section 42 composed of the same composition as that of the first semiconductor section 22, a second supporting section 44 composed of the same composition as that of the second semiconductor section 24, fourth semiconductor sections 152 and 154, and a fifth semiconductor section 156, which are arranged from the side of the substrate 10. A Schottky junction is formed in one of the fourth semiconductor sections 152 and 154 and the fifth semiconductor section 156, thereby composing a Schottky diode.

The fourth semiconductor sections 152 and 154 may be formed with the same composition as that of a part of the third semiconductor sections 26 and 28. In the example shown in FIG. 9, the fourth semiconductor sections 152 and 154 are formed with the same composition as that of a part of the third semiconductor section 26 that is a mirror. More specifically, when the third semiconductor section 26 includes at least two layers of different compositions (for example, at least two AlGaAs layers of different Al compositions), the fourth semiconductor section 154 at the uppermost surface is formed from one of the layers of the third semiconductor section 26 (for example, the layer having a lower Al composition).

The fifth semiconductor section 156 is also formed with the same composition as that of a part of the third semiconductor sections 26 and 28. In the example shown in FIG. 9, the fifth semiconductor section 156 is formed with the same composition as that of a part of the third semiconductor section 26 that is a mirror. More specifically, when the third semiconductor section 26 includes at least two layers of different compositions (for example, at least two AlGaAs layers of different Al compositions), the fifth semiconductor section 156 is formed from the other of the layers (for example, the layer having a higher Al composition).

Concretely, when the third semiconductor section 26 that is a mirror is formed from a predetermined number of pairs of alternately laminated p-type A_{0.9}Ga_{0.1}As layers and p-type Al_{0.15}Ga_{0.85}As layers, the fourth semiconductor section 154 at the uppermost surface is formed from a p-type A_{0.15}Ga_{0.85}As layer, and the fifth semiconductor section 156 is formed from a p-type Al_{0.9}Ga₀As layer. By this, the work function of the fifth semiconductor section 156 is higher than the work function of the fourth semiconductor section 154, such that a Schottky junction can be formed in the fifth semiconductor section 156. It is noted that the fourth semiconductor section 152 may be a remaining portion of the predetermined number of pairs of alternately laminated p-type Al_{0.9}Ga_{0.1}As layers and p-type Al_{0.15}Ga_{0.85}As layers. Also, the ratios of Al compositions are not limited to the above.

Also, when the fourth and fifth semiconductor sections 152 and 154, and 156 are formed with the same composition as that of a portion of the third semiconductor sections 26 and 28, the number of members reduces, the structure is simplified, and the cost of the device can be reduced.

Third and fourth electrodes 34 and 136 for driving are formed at the rectification element section 140.

The third electrode 34 is electrically connected to the fourth semiconductor sections 152 and 154. For example, the fifth semiconductor section 156 may be formed on a part of the fourth semiconductor section 154, and the third electrode 34 may be formed in an exposed area of the fourth semiconductor section 154. In the example shown in FIG. 9, the third electrode 34 is electrically connected to the fourth semiconductor section 154 by ohmic contact. The third electrode 34 may be formed from a multilayer film of a Cr layer, an AuZn layer and an Au layer, which are disposed from the side of the fourth semiconductor section 154, or a multilayer film of a Pt layer, a Ti layer, a Pt layer and an Au layer.

On the other hand, the fourth electrode 136 is electrically connected to the fifth semiconductor section 156, and may be formed, for example, on an upper surface of the fifth semiconductor section 156. In the example shown in FIG. 9, the fourth electrode 136 is electrically connected to the fifth semiconductor section 156 by a Schottky junction. The fourth electrode 136 may be formed from a multilayer film of a Ti layer, a Pt layer and an Au layer, which are disposed from the side of the fifth semiconductor section 156, or may be formed from a multilayer film of a Ti layer and an Au layer, or may be formed from an Au layer, or may be formed from an AlAu layer, or may be formed from amorphous Si and P. It is noted that the details of the fourth electrode 36 described in the first embodiment can be applied to other details of the fourth electrode 136.

The fourth and fifth semiconductor sections 154 and 156 (Schottky diode 160) are connected in parallel between the first and second electrodes 30 and 32, and has a rectification action in a reverse direction with respect to the light emitting element section 20. In the present example, like the first embodiment, the breakdown voltage value of the Schottky diode 160 may also preferably be greater than the drive voltage of the light emitting element section 20. Further, electrical connections among the respective electrodes are made in the same manner as described in the first embodiment. By this, even when a voltage in reverse bias is impressed to the light emitting element section 20, a current flows to the fourth and fifth semiconductor sections 154 and 156 (Schottky diode 160) of the rectification element section 140 that is connected in parallel with the light emitting element section 20. By this, the surface-emitting type device 100 can be considerably improved in its electrostatic breakdown strength against voltages in reverse bias. Accordingly, because electrostatic breakdown in a mounting process can be prevented, it excels in handling and its reliability can be improved.

It is noted that other details of the surface-emitting type device in accordance with the present example include details that can be derived from the explanation of the surface-emitting type device in accordance with the first embodiment described above.

### 2 - 2. Method of Manufacturing Surface-emitting Type Device

FIGS. 10 - 14 are figures showing a method for manufacturing a surface-emitting type device in accordance with the example relating to background of the present invention.

As shown in FIG. 10, on a substrate 10, a first semiconductor layer 80 of a first conductivity type (for example, n-type), a second semiconductor layer 81 that functions as an active layer, and third semiconductor layers 84 and 86 of a second conductivity type (for example, p-type), are formed by epitaxial growth while varying the composition. The first embodiment may be referred to for details of the compositions of these layers.

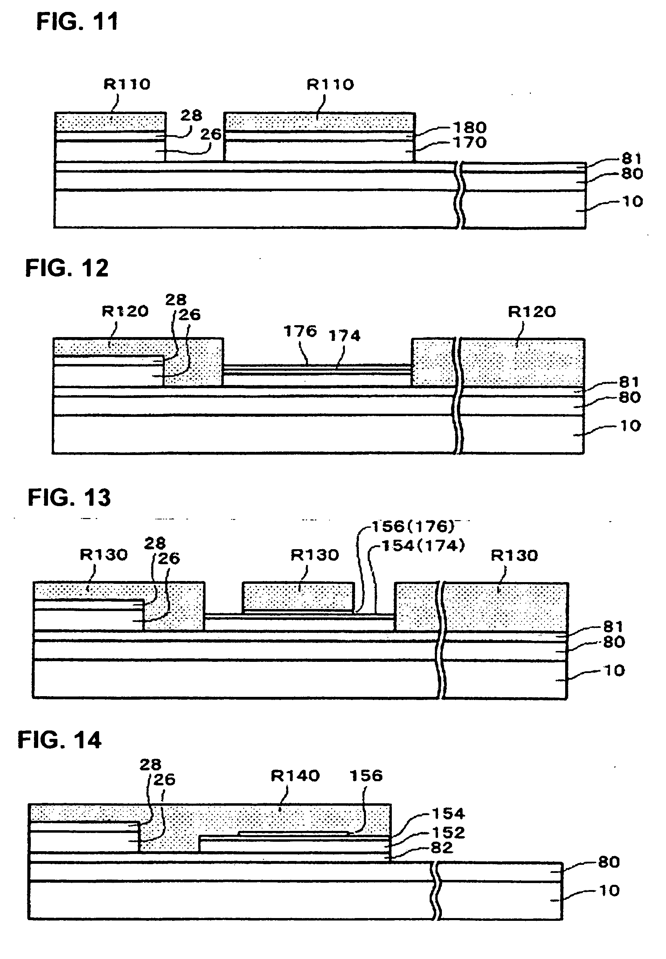

Next, as shown in FIG. 11 - FIG. 14, at least the third semiconductor layers 84 and 88 are patterned to form a light emitting element section 20 and a rectification element section 140.

First, as shown in FIG. 11 - FIG. 13, the third semiconductor layers 84 and 86 are patterned.

As shown in FIG. 11, a resist layer R110 is formed on the third semiconductor layers 84 and 86. The resist layer R110 is formed in areas for the light emitting element section 20 and the rectification element section 140, respectively. Then, by using the resist layer R110 as a mask, the third semiconductor layers 84 and 86 are etched (for example, by dry-etching or wet-etching). In this manner, third semiconductor sections 26 and 28 are formed in the area of the light emitting element section 20, and third semiconductor layers 170 and 180 are formed in the area of the rectification element section 140. The third semiconductor layer 170 is formed with the same composition as that of the third semiconductor section 26 that is a mirror, and the third semiconductor layer 180 is formed with the same composition as that of the third semiconductor section 28 that is a contact section.

Next, as shown in FIG. 12, a resist layer R120 is formed in a region excluding over the third semiconductor layers 170 and 180, and then the third semiconductor layer 180 is entirely removed by etching. The third semiconductor layer 170 includes at least two layers 174 and 176 of different compositions, and a part of the third semiconductor layer 170 is further removed by etching, to thereby expose one of the layers (the layer 176 in FIG. 12). When the third semiconductor section 26 is a mirror, the third semiconductor layer 170 may be formed from, for example, at least two layers of AlGaAs layers of different Al compositions (for example, layers composed of a predetermined number of pairs of alternately laminated p-type Al_{0.9}Ga_{0.1}As layers and p-type Al_{0.15}Ga_{0.85}As layers), and the layer 176 to be exposed may be, for example, the layer with a higher Al composition (concretely, the p-type Al_{0.9}Ga_{0.1}As layer). In the example described in the present example, the layer 176 becomes a fifth semiconductor section 156, and the layer 174 becomes a fourth semiconductor section 154 (see FIG. 13).

Then, as shown in FIG. 13, a resist layer R130 is formed in areas other than the etching region, and a part of the layer 176 is etched and removed by using the resist layer R130 as a mask, to thereby expose the layer 174 (for example, the layer with a lower Al composition (concretely, the p-type Al_{0.15}Ga_{0.85}As layer)). By so doing, a third electrode 34 can be formed on the fourth semiconductor section 154 (layer 174).

Then, as described in the first embodiment, the second semiconductor layer 81 may also be patterned, as shown in FIG. 14. More specifically, a resist layer R140 is formed, and etching is conducted by using the resist layer R140 as a mask, to form a second semiconductor layer 82 and expose at least a part of the first semiconductor layer 80.

It is noted that, without being limited to the order in the above-described patterning method, patterning may be conducted, for example, from the side near the substrate 10, i.e., the second semiconductor layer 81 may be patterned, and then the third semiconductor layers 84 and 86 may be patterned,

Then, as described in the first embodiment, dielectric layers 25 and 45 are formed, and a resist layer 60 is formed. Also, first and second electrodes 30 and 32 for driving the light emitting element section 20 are formed, third and fourth electrodes 34 and 136 for driving the rectification element section 140 are formed, and wirings 70 and 72 for electrically connecting specified ones of the electrodes are formed (see FIG. 9). Details thereof are the same as described in the first embodiment. However, in the present example, in the process of forming electrodes, a Schottky junction is formed in one of the fourth semiconductor sections 152 and 154 and the fifth semiconductor section 156. The fourth electrode 136 may be formed in a manner to form a Schottky junction in the fifth semiconductor section 156, and the third electrode 34 may be formed in a manner to form an ohmic contact in the fourth semiconductor section 154.

In this manner, a Schottky diode 160 is formed with the fourth and fifth semiconductor sections 154 and 156, and the Schottky diode 160 is connected in parallel between the first and second electrodes 30 and 32 in a direction so as to have a rectification action in a reverse direction with respect to the light emitting element section 20. By this, even when a voltage in reverse bias is impressed to the light emitting element section 20, a current flows to the Schottky diode 160, such that the electrostatic breakdown strength against voltages in reverse bias can be considerably improved. Accordingly, electrostatic breakdown in a mounting process or the like can be prevented, and the reliability can be improved.

Also, according to the process described above, compared to the first embodiment, the number of semiconductor layers to be grown on the substrate 10 is fewer, and the step of removing the semiconductor layers on the light emitting element section 20 is not necessary, such that the manufacturing process can be facilitated.

It is noted that other details of the method for manufacturing a surface-emitting type device in accordance with the present example include details that can be derived from the explanation of the method for manufacturing a surface-emitting type device in accordance with the first embodiment.

### Second embodiment

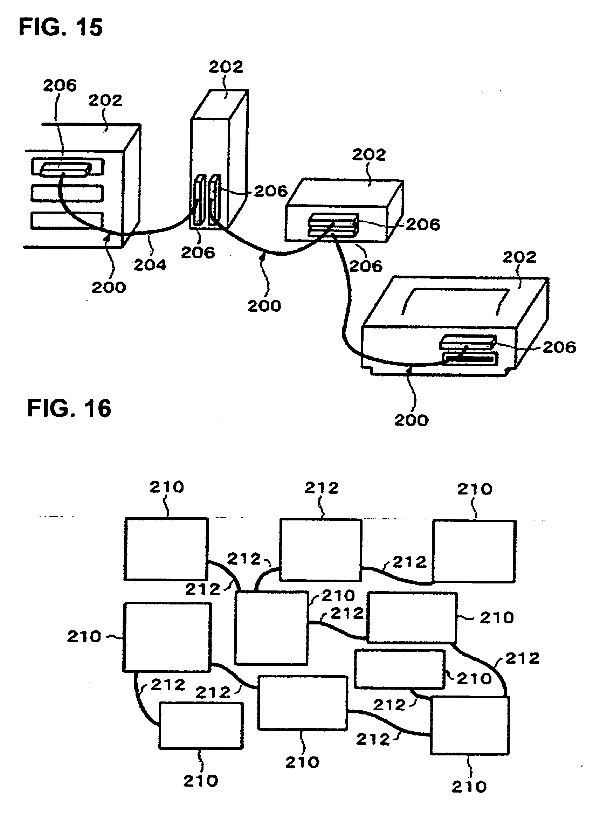

FIG. 15 is a diagram showing optical transmission devices in accordance with a second embodiment of the present invention. The optical transmission devices 200 mutually connect electronic devices 202 such as a computer, a display device, a storage device, a printer and the like. The electronic devices 202 may be information communication devices. The optical transmission device 200 may be provided with a cable 204 and plugs 206 provided on both ends thereof. The cable 204 includes an optical fiber. The plug 206 includes on its inside an optical device (including the surface-emitting type device described above). The plug 206 may further include on its inside a semiconductor chip.

An optical element connected to one of the end sections of the optical fiber is a light emitting element (the surface-emitting type device described above), and an optical element connected to the other end of the optical fiber is a light-receiving element. Electrical signals outputted from the electronic device 202 on one end are converted to optical signals by the light emitting element. The optical signals are transmitted through the optical fiber and inputted in the light-receiving element. The light-receiving element converts the inputted optical signals to electrical signals. Then, the electrical signals are inputted in the electronic device 202 on the other end. In this manner, by the optical transmission device 200 of the present embodiment, information can be transmitted among the electronic devices 202 by optical signals.

### Third embodiment

FIG. 16 is a diagram showing a usage configuration of optical transmission devices in accordance with a third embodiment of the present invention. Optical transmission devices 212 connect electronic devices 210. The electronic devices 210 include, for example, liquid crystal display monitors, digital CRTs (which may be used in the fields of finance, mail order, medical treatment, and education), liquid crystal projectors, plasma display panels (PDP), digital TVs, cash registers of retail stores (for POS (Point of Sale) scanning), videos, tuners, gaming devices, printers and the like.

### Fourth embodiment

### 5 - 1. Surface-emitting Type Device

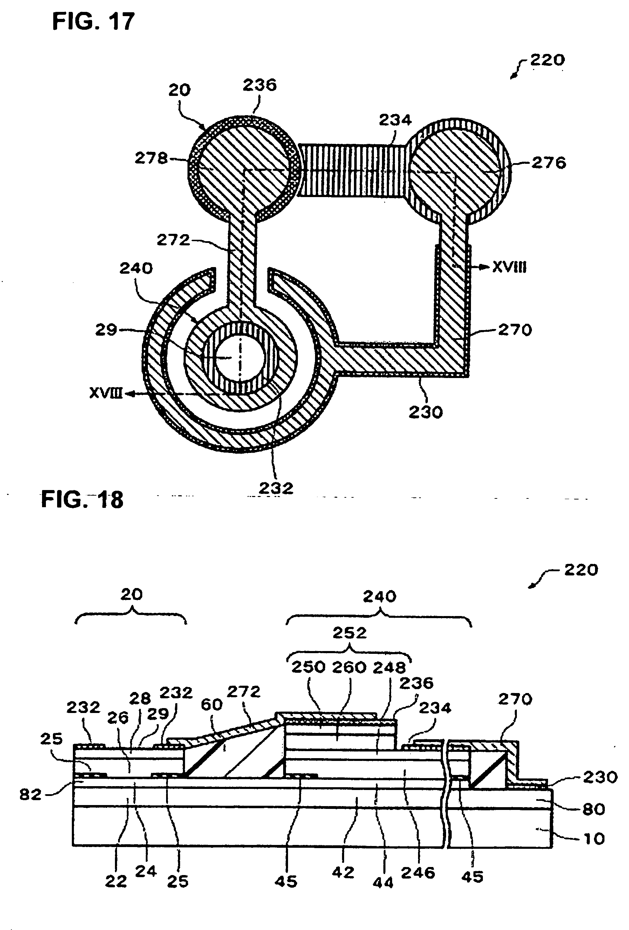

FIG. 17 is a plan view of a surface-emitting type device in accordance with a fourth embodiment of the present invention. FIG. 18 is a cross-sectional view taken along a line XVIII-XVIII of FIG. 17. It is noted that a circuit diagram of the surface-emitting type device in accordance with the present embodiment corresponds to FIG. 3 in the first embodiment. In the present embodiment, a rectification element section 240 and compositions of electrode (wiring) patterns are different from those of the first embodiment.

The surface-emitting type device 220 includes a substrate 10, a light emitting element section 20, and a rectification element section 240. Details of the substrate 10 and the light emitting element 20 are the same as described in the first embodiment.

The rectification element section 240 includes a junction diode 252. More specifically, the rectification element section 240 includes a first supporting section 42 composed of the same composition as that of a first semiconductor section 22, a second supporting section 44 composed of the same composition as that of a second semiconductor section 24, fourth semiconductor sections 246 and 248, a capacitance reducing section 260, and a fifth semiconductor section 250, which are arranged from the side of the substrate 10. The first and second supporting sections 42 and 44 are the same as described in the first embodiment.

The fourth semiconductor sections 246 and 248 are formed in a second conductivity type (for example, p-type), and the fifth semiconductor section 250 is formed in a first conductivity type (for example, n-type). By this, a pn junction diode can be formed by the fourth and fifth semiconductor sections 248 and 250, and the capacitance reducing section 260 provided between them. It is noted that not only the fourth semiconductor section 248 but also the fourth semiconductor section 246 may contribute to operations of the pn junction diode.

The fourth semiconductor sections 246 and 248 may be formed with the same composition as that of third semiconductor sections 26 and 28. In the example shown in FIG. 18, the fourth semiconductor section 246 is formed with the same composition as that of the third semiconductor section 26 that is a mirror, and the fourth semiconductor section 248 is formed with the same composition as that of the third semiconductor section 28 that is a contact section. The fourth semiconductor section 248 at the uppermost surface may be formed with a (for example, p-type) GaAs layer.

In the present embodiment, the fifth semiconductor section 250 is not limited in its material as long as it has a conductivity type different from that of the fourth semiconductor sections 246 and 248. For example, the fifth semiconductor section 250 may be formed in a conductivity type different from that of the fourth semiconductor sections 246 and 248, and with the same composition ((for example, n-type) GaAs layer) as that of at least a part of the fourth semiconductor sections 246 and 248 (for example, the fourth semiconductor section 248).

In the present embodiment, the capacitance reducing section 260 is provided between the fourth and fifth semiconductor sections 248 and 250. By this, the capacitance of the junction diode 252 can be reduced, such that hindrance of high-speed driving of the light emitting element section 20 by the junction diode 252 can be prevented. In particular, in accordance with the present embodiment, because the rectification element section 240 is connected in parallel with respect to the light emitting element section 20, the capacitances of the light emitting element section 20 and the rectification element section 240 influence as an added value. For this reason, the reduction of the capacitance of the junction diode 252 is very effective in driving the surface-emitting type device at higher speeds.

The capacitance reducing section 260 may be provided on a region of a portion of the fourth semiconductor section 248 in order to secure an electrical connection region. The material, thickness and area of the capacitance reducing section 260 can be decided based on the capacitance value of the junction diode 252. To reduce the capacitance of the junction diode 252, a material having a low relative dielectric constant may preferably be used for the capacitance reducing section 260.

The capacitance reducing section 260 may be a semiconductor section (sixth semiconductor section). When the capacitance reducing section 260 is formed from an intrinsic semiconductor, the junction diode 252 can be called a pin diode. It is noted that an intrinsic semiconductor is a semiconductor in which most of the carriers that contribute to electrical conduction are free electrons thermally excited in a conductor from the valence band, or holes in the same number generated in the valence band, and changes in the carrier density due to the presence of impurities and/or lattice defects can be ignored.

Alternatively, the capacitance reducing section 260 may be a semiconductor section of the same conductivity type as that of the fourth semiconductor section 248 (for example, p-type), and has an impurity concentration to be doped lower than that of the fourth semiconductor section 248 (for example, an impurity concentration lower by one digit or more). Alternatively, the capacitance reducing section 260 may be a semiconductor section of the same conductivity type as that of the fifth semiconductor section 250 (for example, n-type), and has an impurity concentration to be doped lower than that of the fifth semiconductor section 250 (for example, an impurity concentration lower by one digit or more).

It is noted that, to reduce the capacitance of the junction diode 252, the thickness of the capacitance reducing section 260 may preferably be made greater, and the area thereof may preferably be made smaller. For example, the capacitance reducing section 260 may have a thickness greater than that of the fourth semiconductor section 248 (or the fifth semiconductor section 250), and an area smaller than that of the fourth semiconductor section 248.

The capacitance reducing section 260 may be formed from, for example, an AlGaAs layer, a GaAs layer or the like. If the capacitance reducing section 260 is formed from a material different from that of the fourth semiconductor section 248 that serves as a ground, a selection ratio in etching can be obtained, such that selective etching of the capacitance reducing section 260 is easy. For example, when the fourth semiconductor section 248 is formed from a GaAs layer, the capacitance reducing section 260 may be formed from an AlGaAs layer.

When the capacitance reducing section 260 is formed from an AlGaAs layer, the ratio of each composition is not particularly limited, but a higher Al composition ratio may be preferred because the relative dielectric constant of the capacitance reducing section 260 can be lowered. The ratio of each composition of an AlGaAs layer of the capacitance reducing section 260 may be defined by, for example, AlₓGa₁₋ₓ As (x ≧0.5). By this, because the Al composition ratio is high, the capacitance of the junction diode 252 can be further reduced, and a sufficient etching selection ratio can be obtained with respect to the aforementioned fourth semiconductor section 248 that serves as a ground.

Next, structures of electrode (wiring) patterns are described.

First and second electrodes 230 and 232 for driving are formed at the light emitting element section 20. The first electrode 230 is electrically connected to the first semiconductor section 22, and may be formed on a first semiconductor layer 80, as described in the first embodiment. The second electrode 232 is electrically connected to the third semiconductor sections 26 and 28, and may be formed, for example, on the third semiconductor section 28 that is a contact section. The second electrode 232 may be formed in a ring shape along an end section of an upper surface of the third semiconductor section 28. Materials of the first and second electrodes 230 and 232 are the same as described in the first embodiment.

Third and fourth electrodes 234 and 236 for driving are formed at the rectification element section 240. The third electrode 234 is electrically connected to the fourth semiconductor sections 246 and 248. For example, the fifth semiconductor section 250 may be formed on a region of a portion of the fourth semiconductor section 248, and the third electrode 234 may be formed in an exposed region of the fourth semiconductor section 248. The third electrode 234 may be formed with the same composition as that of the second electrode 232 corresponding to the same conductivity type (the second conductivity type (for example, p-type)).

The fourth electrode 236 is electrically connected to the fifth semiconductor section 250, and may be formed, for example, on an upper surface of the fifth semiconductor section 250. Because light is not emitted from the upper surface of the fifth semiconductor section 250, the entirety of the upper surface of the fifth semiconductor section 250 may be covered by the fourth electrode 236. The fourth electrode 236 may be formed with the same composition as that of the first electrode 230 corresponding to the same conductivity type (the first conductivity type (for example, n-type)).

A junction diode (pin diode) 252 is connected in parallel between the first and second electrodes 230 and 232, and has a rectification action in a reverse direction with respect to the light emitting element section 20. More specifically, the first and third electrodes 230 and 234 are electrically connected by a wiring 270, and the second and fourth electrodes 232 and 236 are electrically connected by a wiring 272.

In the example shown in FIG. 17, the first electrode 230 includes a portion formed in, for example, a C-shape in a manner to surround an outer circumference of the light emitting element section 20, and a portion that extends in a direction toward the third electrode 234. Then, a major portion of the wiring 270 is disposed on either of the regions of the first and third electrodes 230 and 234. The wiring 270 has an electrical connection section 276 at a portion thereof, and the electrical connection section 276 is formed, for example, on the third electrode 234. Also, the other wiring 272 has an electrical connection section 278 at a portion thereof, and the electrical connection section 278 is formed, for example, on the fourth electrode 236. The electrical connection sections 276 and 278 each may be in a land shape.

It is noted that other details of the surface-emitting type device in accordance with the present embodiment includes details that can be derived from the explanation of the surface-emitting type device in accordance with the first embodiment described above.

### 5 - 2. Method of Manufacturing Surface-emitting Type Device

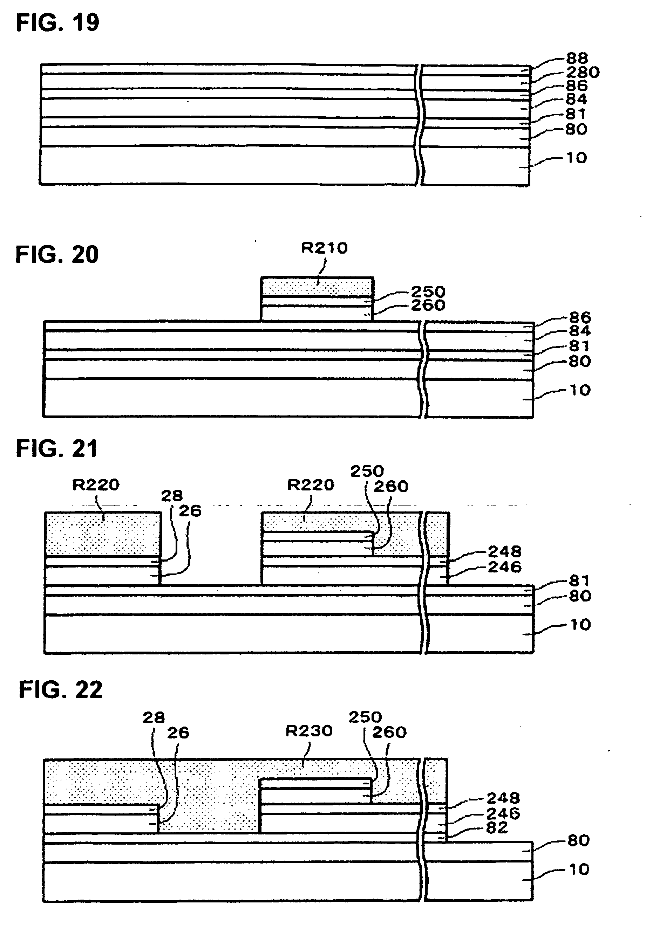

FIGS. 19 - 22 are figures showing a method for manufacturing a surface-emitting type device in accordance with the fourth embodiment of the present invention.

As shown in FIG. 19, on a substrate 10, a first semiconductor layer 80 of a first conductivity type (for example, n-type), a second semiconductor layer 81 that functions as an active layer, and third semiconductor layers 84 and 86 of a second conductivity type (for example, p-type), a capacitance reducing layer 280, and a fourth semiconductor layer 88 of the first conductivity type (for example, n-type) are formed by epitaxial growth while varying the composition. The composition of the capacitance reducing layer 280 corresponds to the details of the capacitance reducing section 260 described above. Details of other layers correspond to the details already described.

Next, as shown in FIG. 20 - FIG. 22, at least the third semiconductor layers 84 and 86, the capacitance reducing layer 280 and the fourth semiconductor layer 88 are patterned, to thereby form a light emitting element section 20 and a rectification element section 240.

First, as shown in FIG. 20, the fourth semiconductor layer 88 at the uppermost layer, and a layer therebelow, i.e., the capacitance reducing layer 280 may be patterned. More specifically, resist is coated on the fourth semiconductor layer 88, and the resist is patterned, thereby forming a resist layer R210 having a predetermined pattern. Then, by using the resist layer R210 as a mask, etching (for example, dry-etching or wet-etching) is conducted. By conducting wet-etching, a surface (the third semiconductor layer 86 including a light emission surface 29) that is newly exposed after etching can be made into a smooth surface. Also, if the capacitance reducing layer 280 is formed from a material different from that of the third semiconductor layer 86 (the layer including the uppermost surface) that serves as a ground, a selection ratio in etching can be obtained, such that selective etching of the capacitance reducing layer 280 is easy. For example, when the third semiconductor layer 86 is formed from a GaAs layer, the capacitance reducing layer 280 may be formed from an AlGaAs layer. The ratio of each composition of an AlGaAs layer of the capacitance reducing layer 280 may be defined by, for example, AlₓGa₁₋ₓ As (x >-_0.5). By this, a sufficient etching selection ratio can be obtained with respect to the aforementioned third semiconductor layer 86 that serves as a ground. Accordingly, better patterning can be performed.

In this manner, after the fifth semiconductor section 250 and the capacitance reducing section 260 are formed, the third semiconductor layers 84 and 86 are patterned, as shown in FIG. 21. More specifically, a resist layer R220 is formed in a similar manner as described above, and etching is conducted by using the resist layer R220 as a mask. By patterning the third semiconductor layer 84, a third semiconductor section 26 that functions as a mirror and a fourth semiconductor section 246 can be formed, and by patterning the third semiconductor layer 86, a third semiconductor section 28 that functions as a contact section and a fourth semiconductor section 248 can be formed.

As shown in FIG. 22, the second semiconductor layer 81 may also be patterned. More specifically, a resist layer R230 is formed in a similar manner as described above, etching is conducted by using the resist layer R230 as a mask, to thereby form a second semiconductor layer 82 and expose at least a portion of the first semiconductor layer 80. By this, a first electrode 230 can be formed in an exposed region of the first semiconductor layer 80.

It is noted that, without being limited to the order in the patterning method described above, patterning can be conducted from, for example, the side closer to the substrate 10, i.e., the second semiconductor layer 81, the third semiconductor layers 84 and 86, the capacitance reducing layer 280 and the semiconductor layer 88 can be patterned in this order.

Then, as described in the first embodiment, dielectric layers 25 and 45 are formed, and a resin layer 60 is formed. Further, first and second electrodes 230 and 232 for driving the light emitting element section 20 are formed, third and fourth electrodes 234 and 236 for driving the rectification element section 240 are formed, and wirings 270 and 272 for electrically connecting specified ones of the electrodes to one another are formed (see FIG. 17 and FIG. 18).

It is noted that other details of the method for manufacturing a surface-emitting type device in accordance with the present embodiment include details that can be derived from the explanation of the method for manufacturing a surface-emitting type device in accordance with the first embodiment.

## Claims

1. A surface-emitting type device comprising:
a substrate (10);
a light emitting element section (20) above the substrate (10), including a first semiconductor section (22) of a first conductivity type, a second semiconductor section (24) that functions as an optically active layer, and a third semiconductor section (26, 28) of a second conductivity type, which are disposed from a side of the substrate (10);
a rectification element section (40) above the substrate (10), including a first supporting section (42) composed of an identical composition of the first semiconductor section (22), a second supporting section (44) composed of an identical composition of the second semiconductor section (24), a fourth semiconductor section (46, 48) of the second conductivity type and a fifth semiconductor section (50) of the first conductivity type, which are disposed from the side of the substrate (10);
first and second electrodes (30, 32) for driving the light emitting element section (20), the first electrode (30) being electrically connected to the first semiconductor section (22) and the second electrode (32) being electrically connected to the third semiconductor section (26, 28); and
third and fourth electrodes (34, 36) for driving the rectification element section (40), the third electrode (34) being electrically connected to the fourth semiconductor section (46, 48) and the fourth electrode (36) being electrically connected to the fifth semiconductor section (50),
wherein a pn junction formed between the fourth and the fifth semiconductor section (46, 48, 50) is connected in parallel between the first and second electrodes (30, 32) in that the third electrode (34) and the first electrode (30) are electrically connected by a first wiring (70) and the fourth electrode (36) and the second electrode (32) are electrically connected by a second wiring (72), and
the pn junction has a rectification action in a reverse direction with respect to the light emitting element section (20).

2. A surface-emitting type device according to claim 1, wherein the fourth semiconductor section (46, 48) is formed with a composition identical with the third semiconductor section (26).

3. A surface-emitting type device according to claim 1 or 2, wherein a capacitance reducing section (260) is provided between the fourth and fifth semiconductor sections (50).

4. A surface-emitting type device according to claim 3, wherein the capacitance reducing section (260) is composed of an intrinsic semiconductor.

5. A surface-emitting type device according to claim 3, wherein the capacitance reducing section (260) is composed of a semiconductor having an impurity concentration lower than the fourth or fifth semiconductor section (250).

6. A surface-emitting type device according to any one of claim 3 through claim 5, wherein the fourth semiconductor section (248) includes a GaAs layer at an uppermost surface, and the capacitance reducing section (260) includes an AlGaAs layer.

7. A surface-emitting type device according to any one of claim 1 through claim 6, wherein
the light emitting element section (20) functions as a surface-emitting type semiconductor laser,
the first semiconductor section (22) functions as a first mirror, and
the third semiconductor section (26) functions as a second mirror.

8. A method for manufacturing a surface-emitting type device, comprising the steps of:
(a) forming, above a substrate (10), a first semiconductor layer of a first conductivity type, a second semiconductor layer that functions as an active layer, a third semiconductor layer of a second conductivity type, and a fourth semiconductor layer of the first conductivity type;
(b) patterning at least the third and fourth semiconductor layers to form a light emitting element section (20) including a first semiconductor section (22) of the first conductivity type, a second semiconductor section (24) that functions as an optically active layer, and a third semiconductor section (26, 28) of the second conductivity type, which are disposed above the substrate (10) from a side of the substrate (10), and a rectification element section (40) including a first supporting section (42) composed of an identical composition of the first semiconductor section (22), a second supporting section (44) composed of an identical composition of the second semiconductor section (24), a fourth semiconductor section (46, 48) of the second conductivity type and a fifth semiconductor section (50) of the first conductivity type, which are disposed above the substrate (10) from the side of the substrate (10);
(c) forming first and second electrodes (30, 32) for driving the light emitting element section (20) and forming third and fourth electrodes (34, 36) for driving the rectification element section (40), the first electrode (30) being electrically connected to the first semiconductor section (22), the second electrode (32) being electrically connected to the third semiconductor section (26, 28), the third electrode (34) being electrically connected to the fourth semiconductor section (46, 48), and the fourth electrode (36) being electrically connected to the fifth semiconductor section (50); and
(d) connecting the pn junction formed between the fourth and the fifth semiconductor section (50) in parallel between the first and second electrodes (30, 32) in that the third electrode (34) and the first electrode (30) are electrically connected by a first wiring (70) and the fourth electrode (36) and the second electrode (32) are electrically connected by a second wiring (72), wherein the pn junction has a rectification action in a reverse direction with respect to the light emitting element section (20).

9. The method of claim 8, wherein
the step (a) further includes forming a capacitance reducing layer between the third and fourth semiconductor layers, and
the step (b) further includes patterning the capacitance reducing layer between the fourth and fifth semiconductor sections (50).

10. The method of claim 9, wherein the third semiconductor layer includes a GaAs layer at a topmost layer, and the capacitance reducing layer includes an AlGaAs layer, wherein the capacitance reducing layer is patterned by wet-etching in the step (b).

## Patentansprüche

1. Oberflächenemittierende Vorrichtung mit:
einem Substrat (10);
einem lichtemittierenden Elementabschnitt (20) über dem Substrat (10), einschließlich eines ersten Halbleiterabschnitts (22) eines ersten Leitfähigkeitstyps, eines zweiten Halbleiterabschnitts (24), der als optisch aktive Schicht fungiert, und eines dritten Halbleiterabschnitts (26, 28) eines zweiten Leitfähigkeittyps, die von einer Seite des Substrats (10) angeordnet sind;
einem Gleichrichtungselementabschnitt (40) über dem Substrat (10), einschließlich eines ersten Stützabschnitts (42), der aus einer identischen Zusammensetzung des ersten Halbleiterabschnitts (22) zusammengesetzt ist, eines zweiten Stützabschnitts (44), der aus einer identischen Zusammensetzung des zweiten Halbleiterabschnitts (24) zusammengesetzt ist, eines vierten Halbleiterabschnitts (46, 48) des zweiten Leitfähigkeitstyps und eines fünften Halbleiterabschnitts (50) des ersten Leitfähigkeitstyps, die von der Seite des Substrats (10) angeordnet sind;
einer ersten und zweiten Elektrode (30, 32) zum Ansteuern des lichtemittierenden Elementabschnitts (20) wobei die erste Elektrode (30) mit dem ersten Halbleiterabschnitt (22) elektrisch verbunden ist und die zweite Elektrode (32) mit dem dritten Halbleiterabschnitt (26, 28) elektrisch verbunden ist; und
einer dritten und vierten Elektrode (34, 36) zum Ansteuern des Gleichrichtungselementabschnitts (40), wobei die dritte Elektrode (34) mit dem vierten Halbleiterabschnitt (46, 48) elektrisch verbunden ist und die vierte Elektrode (36) mit dem fünften Halbleiterabschnitt (50) elektrisch verbunden ist,
wobei ein zwischen dem vierten und dem fünften Halbleiterabschnitt (46, 48, 50) ausgebildeter pn-Übergang parallel zwischen der ersten und zweiten Elektrode (30, 32) **dadurch** verbunden ist, dass die dritte Elektrode (34) und die erste Elektrode (30) durch eine erste Verdrahtung (70) elektrisch verbunden sind und die vierte Elektrode (36) und die zweite Elektrode (32) durch eine zweite Verdrahtung (72) elektrisch verbunden sind, und
der pn-Übergang eine Gleichrichtungshandlung in einer umgekehrten Richtung bezüglich des lichtemittierenden Elementabschnitts (20) aufweist.

2. Oberflächenemittierende Vorrichtung nach Anspruch 1, wobei der vierte Halbleiterabschnitt (46, 48) mit einer Zusammensetzung ausgebildet ist, die mit dem dritten Halbleiterabschnitt (26) identisch ist.

3. Oberflächenemittierende Vorrichtung nach Anspruch 1 oder 2, wobei ein kapazitätsreduzierender Abschnitt (260) zwischen dem vierten und fünften Halbleiterabschnitt (50) vorgesehen ist.

4. Oberflächenemittierende Vorrichtung nach Anspruch 3, wobei der kapazitätsreduzierende Abschnitt (260) aus einem intrinsischen Halbleiter zusammengesetzt ist.

5. Oberflächenemittierende Vorrichtung nach Anspruch 3, wobei der kapazitätsreduzierende Abschnitt (260) aus einem Halbleiter mit einer Verunreinigungskonzentration zusammengesetzt ist, die niedriger als bei dem vierten oder fünften Halbleiterabschnitt (250) ist.

6. Oberflächenemittierende Vorrichtung nach irgendeinem der Ansprüche 3 bis 5, wobei der vierte Halbleiterabschnitt (248) eine GaAs-Schicht an der obersten Fläche einschließt und der kapazitätsreduzierende Abschnitt (260) eine AlGaAs-Schicht einschließt.

7. Oberflächenemittierende Vorrichtung nach irgendeinem der Ansprüche 1 bis 6, wobei
der lichtemittierende Elementabschnitt (20) als oberflächenemittierender Halbleiterlaser fungiert,
der erste Halbleiterabschnitt (22) als ein erster Spiegel fungiert, und
der dritte Halbleiterabschnitt (26) als ein zweiter Spiegel fungiert.

8. Verfahren zum Herstellen einer oberflächenemittierenden Vorrichtung mit den folgenden Schritten:
(a) Ausbilden einer ersten Halbleiterschicht eines ersten Leitfähigkeitstyps, einer zweiten Halbleiterschicht, die als aktive Schicht fungiert, einer dritten Halbleiterschicht eines zweiten Leitfähigkeitstyps und einer vierten Halbleiterschicht des ersten Leitfähigkeitstyps über einem Substrat (10);
(b) Gestalten zumindest der dritten und vierten Halbleiterschicht so, dass sie einen lichtemittierenden Elementabschnitt (20) einschließlich eines ersten Halbleiterabschnitts (22) des ersten Leitfähigkeitstyps bilden, eines zweiten Halbleiterabschnitts (24), der als optisch aktive Schicht fungiert, und eines dritten Halbleiterabschnitts (26, 28) des zweiten Leitfähigkeitstyps, die über dem Substrat (10) von einer Seite des Substrats (10) angeordnet sind, und eines Gleichrichtungselementabschnitts (40) einschließlich eines ersten Stützabschnitts (42), der aus einer identischen Zusammensetzung des ersten Halbleiterabschnitts (22) zusammengesetzt ist, eines zweiten Stützabschnitts (44), der aus einer identischen Zusammensetzung des zweiten Halbleiterabschnitts (24) zusammengesetzt ist, eines vierten Halbleiterabschnitts (46, 48) des zweiten Leitfähigkeitstyps und eines fünften Halbleiterabschnitts (50) des ersten Leitfähigkeitstyps, die über dem Substrat (10) von der Seite des Substrats (10) angeordnet sind;
(c) Ausbilden einer ersten und zweiten Elektrode (30, 32) zum Ansteuern des lichtemittierenden Elementabschnitts (20) und Ausbilden einer dritten und vierten Elektrode (34, 36) zum Ansteuern des Gleichrichtungselementabschnitts (40), wobei die erste Elektrode (30) mit dem ersten Halbleiterabschnitt (22) elektrisch verbunden ist, die zweite Elektrode (32) mit dem dritten Halbleiterabschnitt (26, 28) elektrisch verbunden ist, die dritte Elektrode (34) mit dem vierten Halbleiterabschnitt (46, 48) elektrisch verbunden ist und die vierte Elektrode (36) mit dem fünften Halbleiterabschnitt (50) elektrisch verbunden ist; und
(d) Verbinden des pn-Übergangs, der zwischen dem vierten und dem fünften Halbleiterabschnitt (50) parallel zwischen der ersten und zweiten Elektrode (30, 32) ausgebildet ist, so dass die dritte Elektrode (34) und die erste Elektrode (30) elektrisch durch eine erste Verdrahtung (70) verbunden sind und die vierte Elektrode (36) und die zweite Elektrode (32) durch eine zweite Verdrahtung (72) elektrisch verbunden sind, wobei der pn-Übergang eine Gleichrichtungshandlung in umgekehrter Richtung bezüglich des lichtemittierenden Elementabschnitts (20) aufweist.

9. Verfahren nach Anspruch 8, wobei
der Schritt (a) weiterhin das Ausbilden einer kapazitätsreduzierenden Schicht zwischen der dritten und vierten Halbleiterschicht beinhaltet, und
der Schritt (b) weiterhin das Gestalten der kapazitätsreduzierenden Schicht zwischen dem vierten und fünften Halbleiterabschnitt (50) beinhaltet.

10. Verfahren nach Anspruch 9, wobei die dritte Halbleiterschicht eine GaAs-Schicht an einer obersten Schicht beinhaltet und die kapazitätsreduzierende Schicht eine AlGaAs-Schicht beinhaltet, wobei die kapazitätsreduzierende Schicht durch Nassätzen in Schritt (b) gestaltet wird.

## Revendications

1. Dispositif du type à émission par la surface comprenant :
un substrat (10) ;
une section (20) d'élément émettant de la lumière au-dessus du substrat (10), comprenant une première section (22) semiconductrice d'une conductivité d'un premier type, une deuxième section (24) semiconductrice servant de couche active optiquement et une troisième section (26, 28) semiconductrice d'une conductivité d'un second type, qui sont disposées à partir d'un côté du substrat (10) ;
une section (40) d'élément de redressement au-dessus du substrat (10), comprenant une première section (42) de support d'une composition identique à celle de la première section (22) semiconductrice, une deuxième section (44) de support d'une composition identique à celle de la deuxième section (24) semiconductrice, une quatrième section (46, 48) semiconductrice de la conductivité du second type et une cinquième section (50) semiconductrice de la conductivité du premier type, qui sont disposées à partir du côté du substrat (10) ;
des première et deuxième électrodes (30, 32) pour attaquer la section (20) d'émission de lumière, la première électrode (30) étant reliée électriquement à la première section (22) semiconductrice et la deuxième électrode (32) étant reliée électriquement à la troisième section (26, 28) semiconductrice ; et
des troisième et quatrième électrodes (34, 36) pour attaquer la section (40) d'élément de redressement, la troisième électrode (34) étant reliée électriquement à la quatrième section (46, 48) semiconductrice et la quatrième électrode (36) étant reliée électriquement à la cinquième section (50) semiconductrice,
dans lequel une jonction pn formée entre la quatrième et la cinquième section (46, 48, 50) semiconductrice est montée en parallèle entre la première et la deuxième électrode (30, 32) en ce que la troisième électrode (34) et la première électrode (30) sont reliées électriquement par un premier câblage (70) et la quatrième électrode (36) et la seconde électrode (32) sont reliées électriquement par un deuxième câblage (72), et
la jonction pn a un effet de redressement dans un sens inverse par rapport à la section (20) d'élément émettant de la lumière.

2. Dispositif du type à émission par la surface suivant la revendication 1, dans lequel la quatrième section (46, 48) semiconductrice est formée en ayant une composition identique à celle de la troisième section (26) semiconductrice.

3. Dispositif du type à émission par la surface suivant la revendication 1 ou 2, dans lequel une section (260) réduisant la capacité est prévue entre les quatrième et cinquième sections (50) semiconductrices.

4. Dispositif du type à émission par la surface suivant la revendication 3, dans lequel la section (260) réduisant la capacité est composée d'un semiconducteur intrinsèque.

5. Dispositif du type à émission par la surface suivant la revendication 3, dans lequel la section (260) réduisant la capacité est composée d'un semiconducteur ayant une concentration d'impuretés plus petite que celle de la quatrième ou de la cinquième section (260) semiconductrice.

6. Dispositif du type à émission par la surface suivant l'une quelconque des revendications 3 à 5, dans lequel la quatrième section (248) semiconductrice comprend une couche de GaAs à sa surface la plus haute et la section (260) de réduction de la capacité comprend une couche d'AlGaAs.

7. Dispositif du type à émission par la surface suivant l'une quelconque des revendications 1 à 6, dans lequel
la section (20) d'élément émettant de la lumière sert de laser à semiconducteur du type à émission par la surface,
la première section (22) semiconductrice sert de premier miroir, et
la troisième section (26) semiconductrice sert de deuxième miroir.

8. Procédé de fabrication d'un dispositif du type à émission par la surface, comprenant les stades, dans lesquels :
(a) on forme au-dessus d'un substrat (10) une première couche semiconductrice d'une conductivité d'un premier type, une deuxième couche semiconductrice qui sert de couche active, une troisième couche semiconductrice d'une conductivité d'un second type et une quatrième couche semiconductrice de la conductivité du premier type ;
(b) on structure au moins les troisième et quatrième couches semiconductrices pour former une section (20) d'élément émettant de la lumière, comprenant une première section (22) semiconductrice de la conductivité du premier type, une deuxième section (24) semiconductrice, qui sert de couche active optiquement, et une troisième section (26, 28) semiconductrice de la conductivité du deuxième type, qui sont disposées au-dessus du substrat (10) à partir d'un côté du substrat (10), et une section (40) d'élément de redressement comprenant une première section (42) de support ayant une composition identique à celle de la première section (22) semiconductrice, une deuxième section (44) de support ayant une composition identique à celle de la deuxième section (24) semiconductrice, une quatrième section (46, 48) semiconductrice de la conductivité du deuxième type et une cinquième section (50) semiconductrice de la conductivité du premier type, qui sont disposées au-dessus du substrat (10) à partir du côté du substrat (10 ;
(c)on forme des première et deuxième électrodes (30, 32) pour attaquer la section (20) d'élément émettant de la lumière et on forme des troisième et quatrième électrodes (34, 36) pour attaquer la section (40) d'élément de redressement, la première électrode (30) étant reliée électriquement à la première section (22) semiconductrice, la deuxième électrode (32) étant reliée électriquement à la troisième section (26, 28) semiconductrice, la troisième électrode (34) étant reliée électriquement à la quatrième section (46, 48) semiconductrice et la quatrième électrode (36) étant reliée électriquement à la cinquième section (50) semiconductrice ; et
(d)on monte la jonction pn formée entre la quatrième et la cinquième section (50) semiconductrice en parallèle entre les première et deuxième électrodes (30, 32), en ce que la troisième électrode (34) et la première électrode (30) sont reliées électriquement par un premier câblage (70) et la quatrième électrode (36) et la deuxième électrode (32.) sont reliées électriquement par un deuxième câblage (72), la jonction pn ayant un effet de redressement en sens inverse par rapport à la section (20) d'élément émettant de la lumière.

9. Procédé suivant la revendication 8, dans lequel
le stade (a) comprend, en outre, la formation d'une couche réduisant la capacité entre les troisième et quatrième couches semiconductrices, et
le stade (b) comprend, en outre, la structuration de la couche réduisant la capacité entre la quatrième et la cinquième sections (50) semiconductrices.

10. procédé suivant la revendication 9, dans lequel la troisième couche semiconductrice comprend une couche de GaAs comme couche la plus haute et la couche réduisant la capacité comprend une couche d'AlGaAs, la couche réduisant la capacité étant structurée par attaque en voie humide au stade (b).
